# EUROPEAN PATENT SPECIFICATION

(11) **EP 0 661 730 B1**
(45) Date of publication and mention of the grant of the patent: **01.04.1998**
(21) Application number: 94120738.3
(22) Date of filing: 27.12.1994
(51) Int. Cl.: H01L 21/00, H01L 27/115, H01G 4/06

(54) **Manufacturing method of semiconductor devices**
Verfahren zum Herstellen von Halbleitervorrichtungen
Procédé de fabrication de dispositifs semi-conducteurs

(30) Priority: 28.12.1993 JP 336161/93
(43) Date of publication of application: 05.07.1995
(73) Proprietor: MATSUSHITA ELECTRONICS CORPORATION, Takatsuki-shi, Osaka 569 (JP)
(72) Inventor: Matsumoto, Shoji, Kyoto-shi, Kyoto 612 (JP); Nikou, Hideo, Otsu-shi, Shiga 520-02 (JP); Nakagawa, Satoshi, Mukou-shi, Kyoto 617 (JP)
(74) Representative: Kügele, Bernhard

(56) References cited:
- MATERIALS RESEARCH SOCIETY, SYMPOSIUM PROCEEDINGS, vol.310, 13 April 1993, SAN FRANCISCO, CA, USA pages 127 - 132 VAN GLABBEEK J.J. ET AL. 'Reactive ion etching of PtPbZrTiO3Pt integrated ferroelectric capacitors'
- PATENT ABSTRACTS OF JAPAN vol. 14, no. 187 (E-0917) 16 April 1990 & JP-A-02 034 920 (SONY CORPORATION) 5 February 1988
- PATENT ABSTRACTS OF JAPAN vol. 17, no. 579 (E-1451) 21 October 1993 & JP-A-05 175 174 (NEC CORP) 13 July 1993

## Description

### FIELD OF THE INVENTION

This invention relates to a semiconductor device manufacturing method wherein a capacitance element is formed by first providing, on top of a substrate having already-completed circuit elements and wiring, an insulation layer, a bottom Pt electrode layer, a dielectric film and a top Pt electrode layer, and selectively dry etching said top Pt electrode layer and said dielectric film, and thereafter selectively dry etching said bottom Pt electrode layer.

### BACKGROUND OF THE INVENTION

In the midst of general trends towards finer structuring of semiconductor devices, development activities have been remarkable in the field of microcomputers having capacitors of high dielectric constant materials which is effective to reduce unnecessary radiation, or electro-magnetic interference, and in the field of non-volatile RAM having built-in ferroelectric capacitors which facilitates low-voltage operation and high read/write speed. The ferroelectric materials are made mainly of metal oxide, and contain substantial amount of very reactive oxygen. In forming a capacitor with such dielectric film, material for its electrodes must be least reactive; precious metals such as Pt, palladium, etc. must be used.

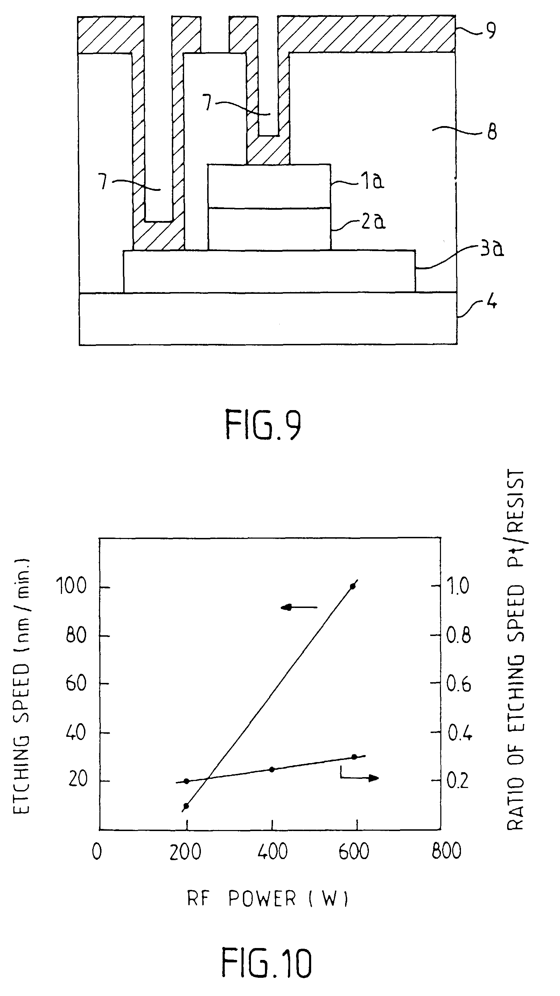

FIG. 9 shows typical structure of capacitor in a semiconductor device having built-in dielectric capacitor. Where, 1a denotes top electrode, 2a capacitance insulation film, 3a bottom electrode, 4 underlayer, 7 contact hole, 8 inter insulation layer (oxide layer) and 9 wiring.

In the above mentioned structure, bottom electrode 3a is made larger than top electrode 1a; the reason is to provide contacting individually at two points, viz. top electrode 1a and bottom electrode 3a, with the upper wiring 9.

Etching process to form the capacitor consists of that of Pt top electrode layer and dielectric film, and that of Pt bottom electrode layer 3; wherein, etching of Pt top electrode layer and dielectic film must be conducted at a speed different from that of Pt bottom electrode.

The Pt etching has been conducted by means of wet etch with aqua regia, ion milling with Ar gas, or by other means. However, the nature of both wet etching and ion milling is isotropic etching, which means the grade of precision is not high enough for the fine pattern processing. Especially, ion milling bears with it a drawback that there is not much difference in etching speed between Pt and underlayer material.

In order to overcome the above mentioned drawback, active research and development efforts have been made in Pt fine pattern processing by means of dry etching; where, as etching gas, use of Cℓ₂ and HBr are reported (Extended Abstracts, Autumn Meeting 1991, The Japan Society of Applied Physics, 9p-ZF-17, p516; Extended Abstracts, Spring Meeting 1993, The Japan Society of Applied Physics, 30a-ZE-3, p577). Now in the following, explanation will be made on dependence of Pt etching speed to high frequency (RF) electric power when Cℓ₂ gas is used as etching gas.

FIG.10 shows dependence of Pt etching speed, and of Pt/resist etching speed ratio to RF power, with Cℓ₂ gas as etching gas. Where, horizontal axis denotes RF power, left vertical axis Pt etching speed, and right vertical axis Pt/resist etching speed ratio.

Facility used for the etching is a magnetron reactive ion etching (RIE) mode dry etcher.

Etching conditions are: Cℓ₂ gas flow 20 SCCM, gas pressure 1 Pa. Wafer temperature during etching is below 20°C because its back surface is cooled with He.

FIG.10 exhibits a trend that Pt etching speed is increased from 10 nm/min. to 100 nm/min. when RF power is raised from 200W to 600W.

Pt/resist etching speed ratio, when RF power is raised from 200W to 600W, also shows upward trend from 0.2 to 0.3; however, the etching speed ratio remains very low. The above quoted papers also report similar results in the dependence of Pt etching speed to RF power when Cℓ₂ gas is used.

In addition, the above quoted papers describe a case where HBr gas was used as etching gas; in which case, according to the papers, Pt etching speed was reported to be 120 nm/min.

In such conventional cases where single substance gas such as Cℓ₂ or HBr is used as etching gas, Pt etching speed is very low; which means it takes very long time to etch Pt of a required thickness (several hundreds nm), therefore, a drawback of deteriorated throughput of production facilities.

Furthermore, the prolonged etching time is liable to cause a problem of etched resist layer during etching time. If resist layer is made thicker, it affects grade of definition, making formation of fine pattern very difficult.

A possibility for increasing Pt/resist etching speed ratio is to add a gas containing carbon component and conduct etching by means of plasma polymerisation while piling up carbon layer. Such a method is described in Document "Materials Research Society, Symposium Proceedings", Vol. 310, April 13, 1993, p. 127-132 : "Reactive ion etching of Pt/Pb Zr Ti O₃/Pt integrated ferroelectric capacitors", Van Glabbeck et al. This article describes the use of Cf₄/Ar gas for etching Pt films.

This procedure, however, causes piling up of carbon layer within reaction chamber, which becomes source of particle generation. This necessitates frequent maintenance servicing of facilities, making operating efficiency poor.

### SUMMARY OF THE INVENTION

Objective of this invention is to offer a new manufacturing method of semiconductor devices, wherein Pt etching speed is increased, hence, throughput of production facilities can be improved.

The objective is reach by a semiconductor device manufacturing method of the type as described above which is characterized in that, prior to or during each of the selective dry etching steps, sulfur is provided at the respective Pt electrode layer so as to form a Pt-S compound in the respective layer, thus increasing the etching rate of said respective electrode layer.

Preferred embodiments are given in the dependent claims.

Sulfur can be provided by using a gas containing S component as etching gas for Pt etching, and/or an etching gas containing S component as additive gas; or by ion implanting sulfur into the respective Pt electrode layer prior to dry etching said respective layer.

Therefore, according to this invention, Pt and S compound is composed during etching. Because boiling point of this compound is far lower than that of Pt, etching speed for Pt layer can be increased to the improved throughput of manufacturing facilities. Pt etching time can be shortened, and resist etching prevented.

### BRIEF DESCRIPTION OF THE DRAWINGS

FIG. 1(1)∼(D) illustrates formation of capacitor in an embodiment of this invention.

FIG. 2 is characteristics chart that shows dependence of Pt etching speed and Pt/resist etching speed ratio to RF power in Embodiment 1 of this invention, with S₂Cℓ₂ gas as etching gas.

FIG.3 is characteristics chart that shows dependence of Pt etching speed to mixing ratio of etching gas between Cℓ₂ gas and S₂Cℓ₂ gas in Embodiment 2 of this invention.

FIG.4 is characteristics chart that shows dependence of Pt etching speed and Pt/resist etching speed ratio to RF power in Embodiment 3 of this invention; where, etching gas was HBr gas, additive gas was H₂S gas.

FIG.5 is characteristics chart that shows dependence of Pt etching speed to mixing ratio between HBr gas and H₂S gas, in Embodiment 3 of this invention.

FIG.6(A)∼(D) illustrate formation of capacitor in Embodiment 4 of this invention.

FIG.7 is characteristics chart that shows dependence of Pt etching speed to RF power in Embodiment 4; where, S was implanted into Pt by means of ion implantation to compose S and Pt compound, and then Pt is etched with Cℓ₂ gas.

FIG. 8 is Pt/S alloy phase diagram.

FIG.9 shows cross-section of typical capacitor manufactured by conventional semiconductor device manufacturing method.

FIG.10 is characteristics chart that shows dependence of Pt etching speed and Pt/resist etching speed ratio to RF power in the above manufacturing method, where, single substance Cℓ₂ gas was used as etching gas.

### DESCRIPTION OF PREFERRED EMBODIMENTS

In the following, explanation will be given of an embodiment of this invention referring to FIGs; where, same part as the conventional structure as shown in FIG.9 is given the same numeral.

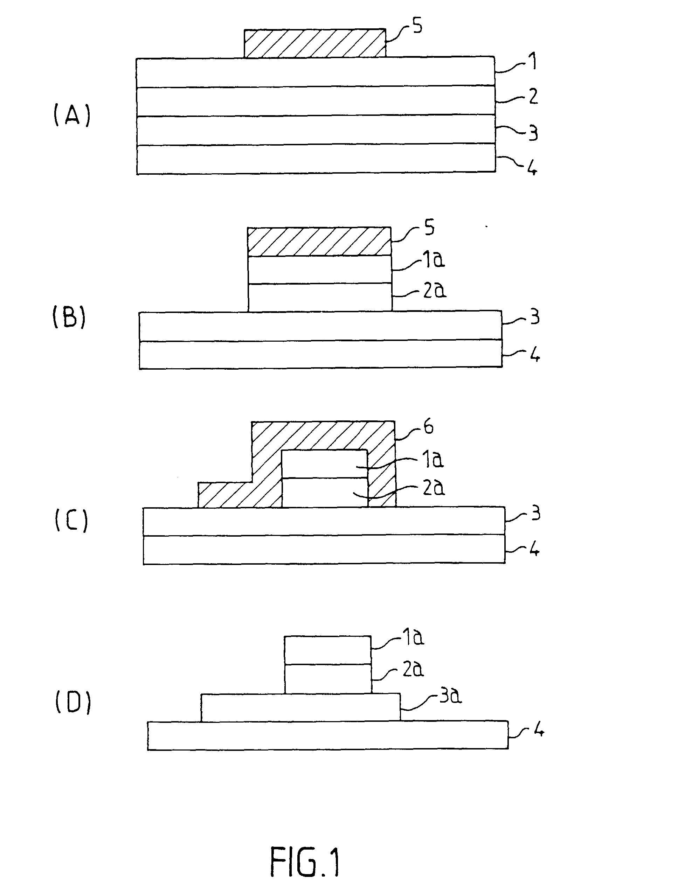

In FIG.1(A)∼(D), 1 denotes Pt layer for top electrode, 1a top electrode, 2 dielectric film, 2a capacitance insulation film, 3 Pt layer for bottom electrode, 4 insulation underlayer, 5 and 6 resists. For the sake of simplifiaction, regions of circuit elements on substrate do not appear in the drawings.

On underlayer 4 provided over silicon semiconductor substrate, pile up 200nm thick Pt layer 3 for bottom electrode; on Pt layer 3 for bottom electrode pile up 180nm thick dielectric film 2; on dielectric film 2 pile up 200nm thick Pt layer 1 for top electrode.

Now, explanation will be made on process to form capacitor out of multi-layered structure thus fabricated.

First, place resist 5 on Pt layer 1 for top electrode, for the purpose of making top electrode 1a and capacitance insulation layer 2a, as shown in FIG.1(A). Next, as shown in FIG.1(B), etch down Pt layer 1 for top electrode and dielectric film 2 to form top electrode 1a and capacitance insulation layer 2a; and stop etching when surface of Pt layer 3 for bottom electrode is exposed. Then, place resist 6 to entirely cover top electrode 1a and capacitance insulation layer 2a, as shown in FIG.1(C). Finally, etch down Pt layer 3 for bottom electrode to form bottom electrode 3a, as shown in FIG.1(D).

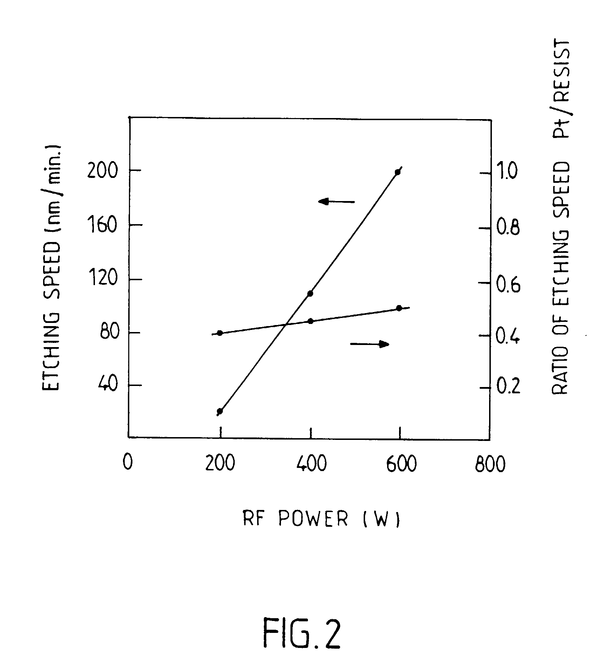

As Embodiment 1 to manufacture capacitor of above mentioned structure, S₂Cℓ₂ gas is used as Pt etching gas. FIG.2 shows Pt etching speed and Pt/resist etching speed ratio under a changing RF power in this Embodiment.

Comparison between FIG.2, characteristics of in this Embodiment, and FIG.10, those in conventional manufacturing method, clarifies that Pt etching speed in this Embodiment is twice as high, and Pt/resist etching speed ratio rises from 0.4 to 0.5 along with the increased RF power from 200W to 600W. Furthermore, Pt/resist etching speed ratio has been almost doubled.

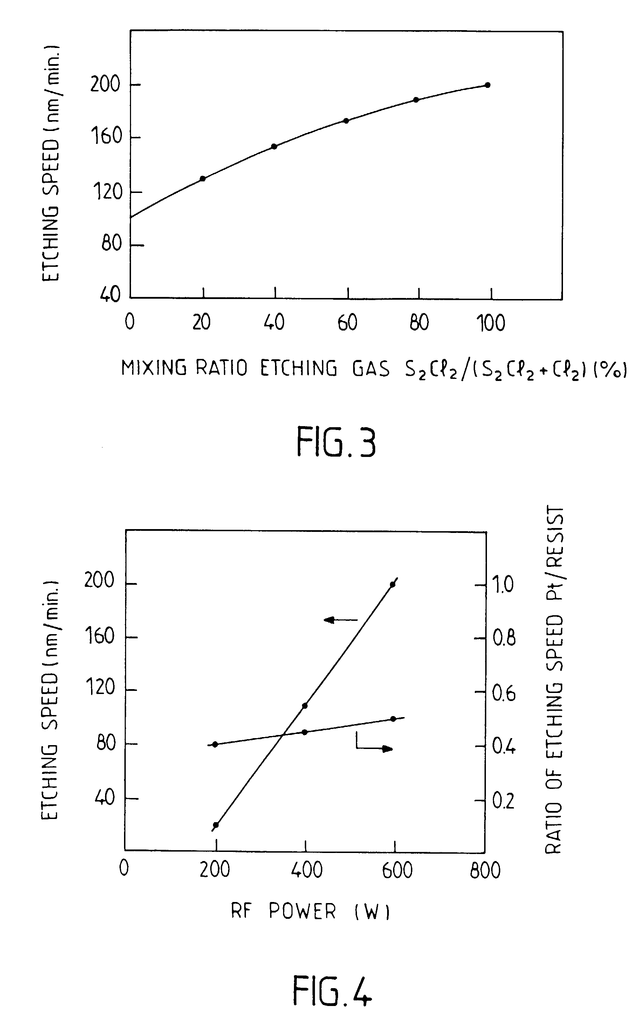

FIG.3 shows, as Embodiment 2, dependence of Pt etching speed to mixing ratio of etching gas when Cℓ₂ gas and S₂Cℓ₂ gas are mixed and used as etching gas. Horizontal axis denotes gas mixing ratio, vertical axis Pt etching speed.

Facility used is a magnetron RIE mode dry etcher.

Etching conditions are: mixing ratio of S₂Cℓ₂/(S₂Cℓ₂+Cℓ₂) etching gas is varied, RF power 600W. gas pressure 1 Pa. Wafer temperature during etching is maintained below 20°C by means of wafer back surface cooling.

FIG.3 clarifies that Pt etching speed follows the upward trend from 100 nm/min. to 200 nm/min. when mixing ratio of etching gas is changed from 100% Cℓ₂ gas to 100% S₂Cℓ₂ gas.

According to this Embodiment case, Pt etching speed can be increased by the use of an etching gas containing S component, and throughput of production facilities can be raised, and Pt/resist etching speed ratio can be made higher.

In this Embodiment case, use of sulfur chloride gas such as S₂Cℓ₂ gas or use of Cℓ₂ and S₂Cℓ₂ mixed gas were exampled as etching gas. However, as the gas containing S component, sulfur fluoride gas such as SF₆ gas or S₂F₂ gas may be used to obtain same results.

As Embodiment 3, a case when H₂S gas is added to etching gas in Pt etching process will be explained referring to FIGs.

FIG.4 shows dependence Pt etching speed and Pt/resist etching speed ratio to RF power when HBr gas is used as etching gas, and H₂S gas as additive gas. Horizontal axis denotes RF power, left vertical axis Pt etching speed, right vertical axis Pt/resist etching speed ratio.

Facilities used is a magnetron RIE mode dry etcher.

Etching conditions are: HBr gas flow 20 SCCM, H₂S gas flow 10 SCCM, gas pressure 1 Pa. Wafer temperature during etching is maintained below 20°C by means of wafer back surface cooling.

FIG.4 clarifies that Pt etching speed follows the upward trend from 20 nm/min. to 200 nm/min. when RF power is increased from 200W to 600W; as compared with conventional case shown in FIG.10, Pt etching speed is almost doubled. Pt/resist etching speed ratio follows the upward trend from 0.4 to 0.5 as RF power increases from 200W to 600W. As compared with the case when Cℓ₂ gas was used as Pt etching gas, the etching speed ratio with resist is almost doubled.

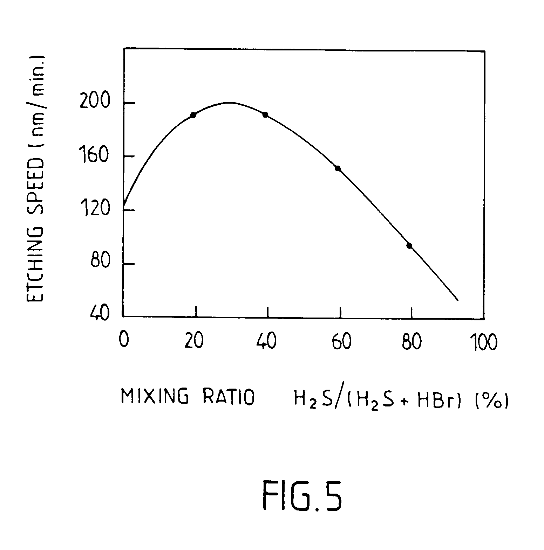

FIG.5 shows dependence of Pt etching speed to mixing ratio of gas when HBr gas is used as etching gas, H₂S gas as additive gas. Horizontal axis denotes gas mixing ratio, vertical axis Pt etching speed.

Facility used is a magnetron RIE mode dry etcher. Etching conditions are: H₂S/(H₂S+HBr) mixing ratio is varied, RF power 600W, gas pressure 1 Pa. Wafer temperature during etching is maintained below 20°C by means of wafer back surface cooling.

FIG.5 clarifies that Pt etching speed reaches the fastest, 200 nm/min., when gas mixture ratio is around 30%.

According to this Embodiment case, Pt etching speed can be increased by the use of a gas containing S component as additive gas, and throughput of production facilities can be raised, and Pt/resist etching speed ratio can be made high.

In this Embodiment case, use of H₂S gas as additive gas was exampled. However, as the gas containing S component, SO₂ gas may be used to obtain same results.

Next, as Embodiment 4 of this invention, explanation will be made on a case where S is implanted into Pt by means of ion implantation to compose S and Pt compound; and then Pt is dry etched.

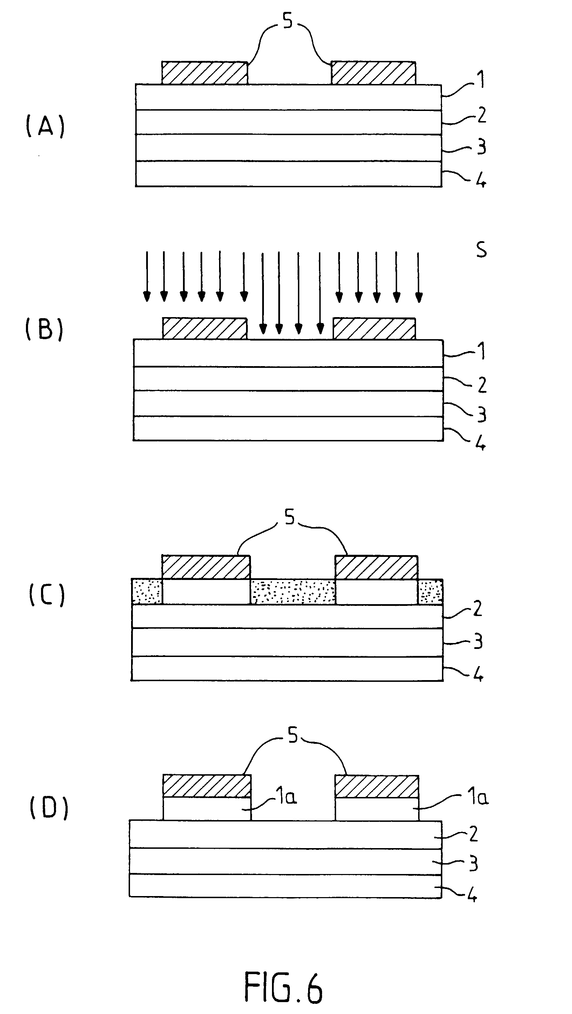

FIG.6(A)∼(D) illustrates formation of capacitor in this Embodiment case; where, 1 is Pt layer for top electrode, 1a top electrode, 2 dielectric film, 3 Pt layer for bottom electrode, 4 underlayer made of insulation layer, 5 resist.

On underlayer 4 provided over silicon semiconductor substrate, pile up 200nm thick Pt layer 3 for bottom electrode; on Pt layer 3 for bottom electrode pile up 180nm thick dielectric film 2; on dielectric film 2 pile up 200nm thick Pt layer 1 for top electrode.

Now, explanation will be made on process to form capacitor out of multi-layered structure thus fabricated.

First, place resist 5 on Pt layer 1 for top electrode, as shown in FIG.6(A). Next, as shown in FIG.6(B), implant S ion into Pt layer 1 for top electrode by means of ion implantation to compose a compound of Pt and S in the region to be etched off, as shown in FIG.6(C). In this stage, S is not implanted into dielectric film 2. Then, as FIG.6(D) illustrates, etch off the Pt and S compound.

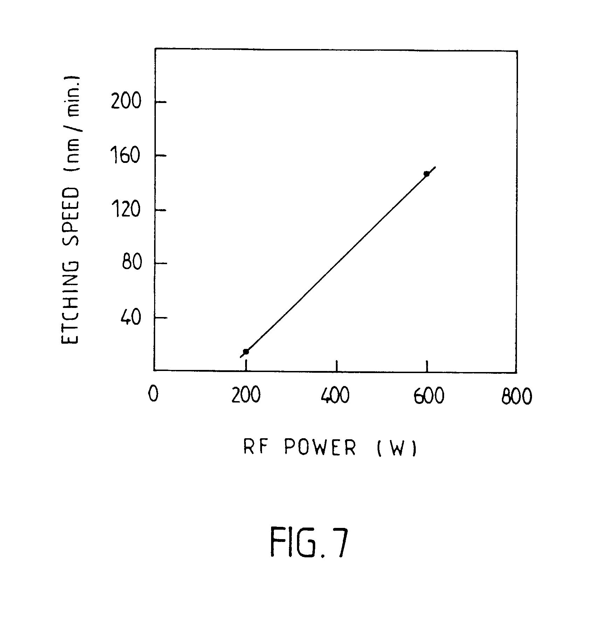

FIG.7 shows dependence of Pt etching speed to RF power, wherein, S is implanted into Pt by means of ion implantation to compose S and Pt compound, and then Cℓ₂ gas is used as etching gas. Horizontal axis denotes RF power, vertical axis Pt etching speed.

Facilities used is a magnetron RIE mode dry etcher. Ion implantation conditions are: acceleration voltage 600KeV, dope quantity 5×10¹⁵atm/cm². Etching conditions are: Cℓ₂ gas flow 20 SCCM, gas pressure 1 Pa. Wafer temperature during etching is maintained below 20°C by means of wafer back surface cooling.

FIG.7 clarifies that Pt etching speed follows upward trend from 15 nm/min. to 150 nm/min. when RF power is raised from 200W to 600W.

As compared with FIG.10, conventional case, Pt etching speed is about 1.5 times as high.

According to this Embodiment case, etching speed of Pt layer 1 for top electrode can be increased by first implanting S into Pt layer 1 for top electrode by means of ion implantation to compose S and Pt compound, and then dry etching the compound. By so doing, throughput of production facilities can be improved.

Now, regarding a case, wherein a gas containing S component is used as etching gas and a gas containing S component is used as additive gas, and another case, wherein Pt is dry etched while Pt and S compound is being composed, or Pt and S compound is first composed and then Pt is dry etched, explanation will be made on the mechanism how Pt etching speed is increased.

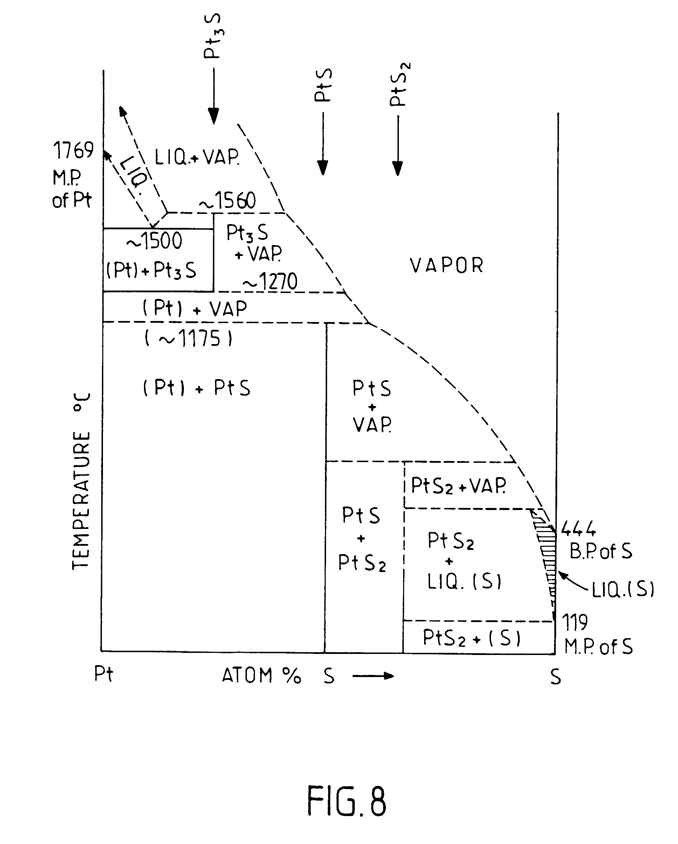

FIG.8 is Pt/S alloy phase diagram, in which one will see that by mixing very small quantity of S into Pt, it starts evaporating at 1175°C.

It is known that boiling point of Pt is as high as 3804°C. However, as mentioned above, boiling point of Pt is lowered by mixing a very small quantity of S into Pt.

S₂Cℓ₂ gas and S₂F₂ gas, both are S-containing gas, have large S/X ratio (X=Cℓ, F) and easily pile up S when dissociated in plasma.

Therefore, when S-containing gas is used as etching gas and S-containing gas is used as additive gas, the S component dissociated in plasma reacts with Pt to compose a low boiling point compound. Because of this, Pt etching speed is increased as compared with the case when Cℓ₂ gas is used as etching gas.

So, in the process where Pt layer 1 for top electrode and dielectric film 2 are to be etched, conduct etching under relatively slow Pt etching conditions, and stop it as soon as Pt layer 3 for bottom electrode is exposed. In the next process where Pt layer 3 for bottom electrode is to be etched, conduct etching under fast Pt etching conditions. In this way, required capacitor structure may be formed.

As the above mentioned Embodiments clarified, the process according to this invention uses a S-containing gas as Pt etching gas, or a gas containing S component as additive gas to change Pt for electrode into low boiling point S/Pt compound; and conducts etching after compound is composed;
therefore, Pt etching speed can be increased. Etching speed ratio with respect to resist can also be increased.

This invention, therefore, implements new manufacturing method of semiconductor devices which provides high processing accuracy and high throughput of production facilities.

## Claims

1. Semiconductor device manufacturing method wherein a capacitance element is formed by :
first providing, on top of a substrate having already-completed circuit elements and wiring, an insulation layer (4), a bottom Pt electrode layer (3), a dielectric film (2) and a top Pt electrode layer (1);
selectively dry etching said top Pt electrode layer and said dielectric film, and thereafter selectively dry etching said bottom Pt electrode layer ; whereby
prior to or during each of the selective dry etching steps, sulfur is provided at the respective Pt electrode layer so as to form a Pt-S compound in the respective layer, thus increasing the etching rate of said respective electrode layer.

2. Semiconductor device manufacturing method according to claim 1, wherein said sulfur is provided by using a S-containing gas as the etching gas.

3. Semiconductor device manufacturing method according to claim 2, wherein the S-containing etching gas is either sulfur fluoride or sulfur chloride.

4. Semiconductor device manufacturing method according to claim 1, wherein the sulfur is provided by using a S-containing additive gas in the etching gas.

5. Semiconductor device manufacturing method according to claim 4, wherein the S-containing additive gas is at least one member selected from the group consisting of sulfur fluoride, sulfur chloride, H₂S and SO₂.

6. Semiconductor device manufacturing method according to claim 1, wherein said sulfur is provided by ion implanting sulfur into the respective Pt electrode layer prior to dry etching said respective layer.

7. Semiconductor device manufacturing method according to claim 1, wherein said sulfur is provided by using a S-containing gas as etching gas, and a S-containing gas as additive gas.

## Patentansprüche

1. Verfahren zum Herstellen von Halbleitervorrichtungen, bei dem ein Kapazitätselement gebildet wird, indem
zuerst an der Oberseite eines Substrates mit bereits fertigen Schaltungselementen und einer Verdrahtung eine Isolierschicht (4), eine Pt-Schicht (3) einer Bodenelektrode, eine dieelektrische Schicht (2) und eine obere Pt-Elektrodenschicht (1) vorgesehen werden;
die obere Pt-Elektrodenschicht sowie die dieelektrische Schicht selektiv trockengeätzt, und hierauf selektiv die Pt-Schicht der Bodenelektrode trockengeätzt wird; wobei
vor oder während jedes der selektiven Trockenätzschritte an der jeweiligen Pt-Elektrodenschicht Schwefel vorgesehen wird, so daß in der jeweiligen Schicht eine Pt-S-Verbindung gebildet wird, womit die Ätzgeschwindigkeit an der jeweiligen Elektrodenschicht erhöht wird.

2. Verfahren zum Herstellen von Halbleitervorrichtungen nach Anspruch 1, bei dem der Schwefel durch Benützung eines S enthaltenden Gases als Ätzgas geliefert wird.

3. Verfahren zum Herstellen von Halbleitervorrichtungen nach Anspruch 2, bei dem das S enthaltende Gas entweder Schwefelfluorid oder Schwefelchlorid ist.

4. Verfahren zum Herstellen von Halbleitervorrichtungen nach Anspruch 1, bei dem der Schwefel durch Benützung eines S enthaltenden Zusatzgases im Ätzgas geliefert wird.

5. Verfahren zum Herstellen von Halbleitervorrichtungen nach Anspruch 4, bei dem das S enthaltende Zusatzgas wenigstens ein aus der aus Schwefelfluorid, Schwefelchlorid, H₂S und SO₂ bestehenden Gruppe gewählter Vertreter ist.

6. Verfahren zum Herstellen von Halbleitervorrichtungen nach Anspruch 1, bei dem der Schwefel durch Ionenimplantieren von Schwefel in die jeweilige Pt-Elektrodenschicht vor dem Trokkenätzen der jeweiligen Schicht geliefert wird.

7. Verfahren zum Herstellen von Halbleitervorrichtungen nach Anspruch 1, bei dem der Schwefel durch Benutzung eines S-enthaltenden Gases als Ätzgas sowie eines S-enthaltenden Gases als Zusatzgas geliefert wird.

## Revendications

1. Procédé de fabrication d'un dispositif semi-conducteur dans lequel un élément capacitif est formé par les étapes suivantes :
premièrement, réalisation sur le dessus d'un substrat comportant des éléments de circuits et des connections déjà disposés, d'une couche d'isolation (4), d'une couche d'électrode de Pt inférieure (3), d'un film diélectrique (2) et d'une couche d'électrode supérieure de Pot (1) ;
gravure sèche de manière sélective de ladite couche d'électrode supérieure de Pt et dudit film diélectrique, et par la suite gravure sèche de manière sélective de ladite couche d'électrode inférieure Pt ; dans lequel
avant ou pendant chacune des étapes de gravure sèche sélective, du soufre est fourni à la couche d'électrode respective de Pt de manière à former un composé Pt-S dans la couche respective, augmentant ainsi la vitesse de gravure de ladite couche d'électrode respective.

2. Procédé de fabrication d'un dispositif semi-conducteur selon la revendication 1, dans lequel ledit soufre est fourni en utilisant un gaz contenant du S comme gaz de gravure.

3. Procédé de fabrication d'un dispositif semi-conducteur selon la revendication 2, dans lequel le gaz de gravure contenant du S est soit du chlorure de soufre soit du fluorure de soufre.

4. Procédé de fabrication d'un dispositif semi-conducteur selon la revendication 1, dans lequel le soufre est fourni en utilisant un gaz additif contenant du S dans le gaz de gravure.

5. Procédé de fabrication d'un dispositif semi-conducteur selon la revendication 4, dans lequel le gaz additif contenant du S est au moins un élément sélectionné parmi le groupe constitué du fluorure de soufre, du chlorure de soufre, du H₂S et du SO₂.

6. Procédé de fabrication d'un dispositif semi-conducteur selon la revendication 1, dans lequel ledit soufre est fourni par implantation ionique de sulfure dans la couche d'électrode de Pt respective avant la gravure sèche de ladite couche respective.

7. Procédé de fabrication d'un dispositif semi-conducteur selon la revendication 1, dans lequel ledit soufre est fourni en utilisant un gaz contenant du S comme gaz de gravure, et un gaz contenant du S comme gaz additif.
